# FASCICULE DE BREVET EUROPEEN

(11) **EP 0 867 726 B1**
(45) Date de publication et mention de la délivrance du brevet: **21.01.2004**
(21) Numéro de dépôt: 97104959.8
(22) Date de dépôt: 24.03.1997
(51) Int. Cl.: G01R 31/02, G01R 31/06

(54) **Méthode de mesure pour détecter un court-circuit entre des spires d'une bobine intégrée sur une puce, et structure de circuit intégré adaptée à une telle méthode de mesure**
Messverfahren zur Feststellung eines Kurzschlusses zwischen den Windungen einer auf einem Chip integrierten Spule und auf ein solches Messverfahren zugeschnit- tene integrierte Schaltung
Measuring method for detecting of a short circuit between windings of a coil integrated on a chip, and integrated circuit adapted to such a measuring method

(43) Date de publication de la demande: 30.09.1998
(73) Titulaire: EM Microelectronic-Marin SA, 2074 Marin (CH)
(72) Inventeur: Kunz, Pascal, 2000 Neuchâtel (CH); Banyai, Antal, 2000 Neuchâtel (CH)
(74) Mandataire: Balsters, Robert

(56) Documents cités:
- EP-A- 0 655 628
- WO-A-88/00785
- DE-B- 1 178 938
- TECHNICAL DIGEST - WESTERN ELECTRIC, no. 36, Octobre 1974, NEW YORK US, pages 23-24, XP002039215 MILA: "TESTING TWISTED PAIRS FOR OPENS,SHORTS,..."

## Description

La présente invention concerne une méthode de mesure de circuit intégré sur puce et, plus particulièrement, une méthode de mesure pour détecter un court-circuit entre deux spires d'une bobine intégrée sur une puce, ainsi qu'une structure de circuit intégré adaptée à une telle méthode de mesure.

On utilise couramment des bobines dans des structures de circuit intégré. A titre d'exemple, le document WO 88/00785 décrit un dispositif de transpondeur 1 formé dans un substrat 2 et comprenant essentiellement une bobine 5 constituée de plusieurs spires 6. A titre illustratif, cette structure comprend en outre divers circuits intégrés 3, 4.

Le document EP 0 655 628 décrit une bobine de circuit intégré comprenant des plots de contact.

Un problème rencontré dans de telles structures réside dans le fait que des courts-circuits peuvent se produire entre deux spires d'une telle bobine lors d'une étape ultérieure de la filière de fabrication des structures intégrées. Ceci peut perturber notablement le fonctionnement de la bobine, et peut être particulièrement gênant dans le cas où le nombre de spires de bobine ou l'inductance de la bobine sont des paramètres importants pour certaines applications, telle que l'utilisation de la bobine comme antenne d'un transpondeur.

TECHNICAL DIGEST - WESTERN ELECTRIC, no. 36, Octobre 1974, NEW YORK US, pages 23-24, XP002039215 MILA: "TESTING TWISTED PAIRS FOR OPENS,SHORTS,..." décrit la détection de courts-circuits dans une bobine par une mesure de la résistance des brins.

Un objet de la présente invention est de prévoir une méthode de mesure pour détecter un court-circuit entre deux spires d'une bobine intégrée sur une puce, pour éviter un fonctionnement perturbé de ladite bobine.

Un autre objet de la présente invention est de prévoir une méthode de mesure qui réponde aux critères traditionnels en industrie, de coût, de simplicité et de rapidité d'exécution.

Ces objets, ainsi que d'autres, sont atteints par la méthode de mesure selon la revendication 1.

Un avantage de la présente invention est de fournir une méthode de mesure qui ne nécessite pas le recours à des équipements spécifiques, ce qui rend cette méthode peu coûteuse.

Un autre avantage de la présente invention est de fournir une méthode basée essentiellement sur deux mesures de résistance, ce qui rend cette méthode simple et rapide.

Un autre avantage de la présente invention est de fournir une méthode qui ne dépend pas de paramètres variables de type technologique ou environnemental, ce qui rend cette méthode de mesure particulièrement fiable et précise.

Un autre objet de la présente invention est de prévoir une structure de circuit intégré adaptée à la méthode de mesure selon la présente invention.

Un autre objet de la présente invention est de prévoir une telle structure de circuit intégré qui réponde aux critères traditionnels en industrie, de coût, de simplicité et de rapidité d'exécution.

Ces objets, ainsi que d'autres, sont atteints par la structure selon la revendication 2.

Un avantage de la présente invention est de fournir une structure de circuit intégré de même complexité que des structures classiques, qui ne nécessitent pas d'étape de fabrication supplémentaire.

Les objets, caractéristiques et avantages de la présente invention apparaîtront plus clairement à la lecture de la description détaillée d'un mode de réalisation préféré de l'invention, donné à titre d'exemple uniquement, en relation avec les figures jointes, parmi lesquelles :
- la figure 1 déjà citée représente une structure classique de circuit intégré comprenant une bobine à spires multiples, et
- la figure 2 représente un exemple de structure de circuit intégré adaptée à la mise en oeuvre de la méthode de mesure selon la présente invention.

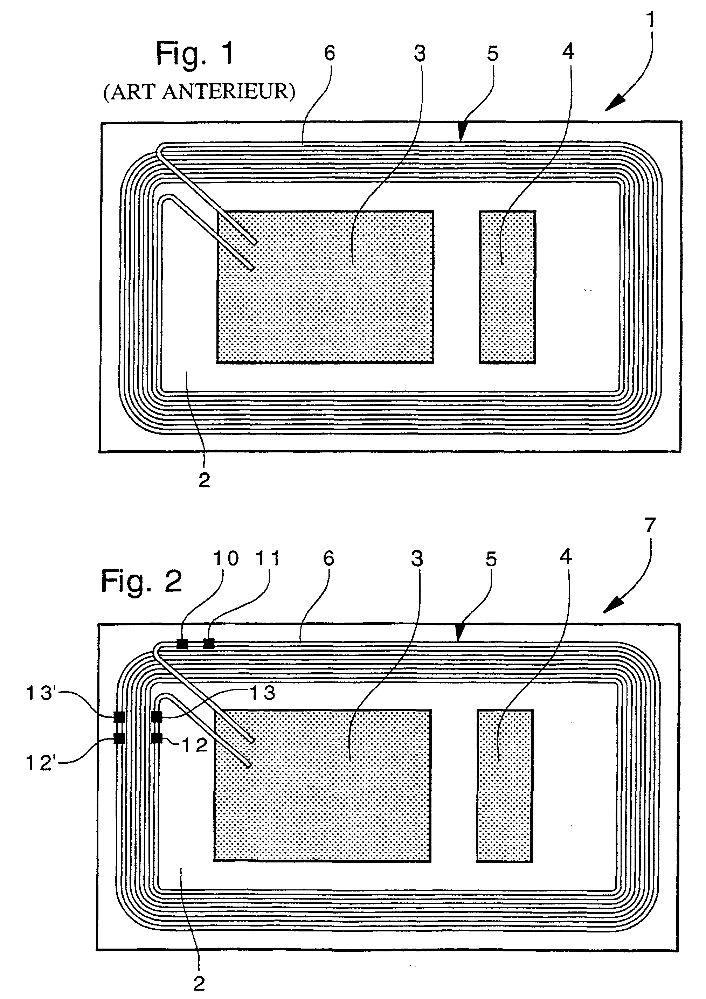

La figure 2 représente un exemple de structure de circuit intégré selon la présente invention.

Une structure de circuit intégré 7 représentée en figure 2 est proche de la structure de circuit intégré décrite ci-dessus en relation avec la figure 1. Ainsi, par souci de simplicité, les composants représentés en figure 2, et désignés par les mêmes références que ceux représentés en figures 1 sont sensiblement identiques à ceux désignés en figure 1.

La structure de circuit intégré 7 formée de façon monolithique dans un substrat 2 est constituée de différents éléments de circuit intégré 3, 4 et d'une bobine d'antenne 5 formée par plusieurs spires conductrices 6.

La structure de circuit intégré 7 comprend en outre des plots de contact 10, 11, 12, 13, 12' et 13' formés sur les spires 6 de la bobine 5, de telle sorte que les plots de contact 10, 13 et 13' sont situés respectivement à proximité des plots de contact 11, 12 et 12', comme cela est représenté en figure 2. L'homme de l'art notera que ces plots de contact peuvent être aisément réalisés par des procédés de fabrication connus dans la technique, qui n'occasionnent pas de difficultés particulières relativement à la structure de la bobine 5, et à sa réalisation.

Les plots de contact 10, 11, 12, 13, 12' et 13' sont destinés à réaliser le contact entre la bobine 5 et chacune des quatre pointes d'une machine de mesure communément utilisée pour réaliser des mesures de paramètres électriques sur des structures de circuit intégré.

Le fonctionnement d'une telle machine de test est supposé connu par l'homme de l'art, et ne sera donc pas abordé de façon détaillée dans le cadre de la description suivante. Pour l'essentiel, le principe de fonctionnement d'une telle machine est le suivant. Un courant est fourni localement à la bobine 5, par la pointe posée sur le plot de contact 10. Ce courant est reçu par une deuxième pointe posée sur le plot de contact 13. Ainsi, ledit courant traverse un certain nombre de spires, ce nombre étant prédéterminé et égal au nombre de spires de bobine comprise entre les plots de contact 10 et 13. Simultanément, les troisième et quatrième pointes posées sur les plots de contact 11 et 12 sont situées par définition à proximité des pointes 10 et 13, respectivement, et sont destinées à mesurer la tension entre les pointes 11 et 12, ladite mesure étant réalisée par un appareil de mesure de tension à haute impédance. Comme les pointes 10 et 13 sont respectivement au voisinage des pointes 11 et 12, on connaît ainsi le courant et la tension aux bornes du nombre prédéterminé de spires de bobine, et on connaît donc la résistance d'un nombre prédéterminé de spires. Un avantage d'une mesure de résistance sur une telle machine de test est de fournir des mesures de résistance indépendantes des contacts entres les pointes de ladite machine et les plots de contacts respectifs.

A titre d'exemple, la figure 2 représente les plots de contact 10, 11, 12, 13, 12' et 13' correspondant à deux mesures de résistance différentes : une première mesure de résistance R1 de l'ensemble de la bobine 5, et une seconde mesure de résistance R2 d'une partie de la bobine 5. Il va de soi que le choix des nombres de spires mesurées lors de la seconde mesure, comme cela est représenté en figure 2, est purement illustratif, et n'est donné qu'à titre d'exemple.

Lorsqu'il ne se produit aucun court-circuit entre deus spires, la valeur du rapport R1/R2 entre les deux mesures de résistance R1 et R2 précédemment mesurées est égale à une constante C. En outre, la constante C peut être préalablement calculée à partir d'un ensemble de mesures de résistances sur d'autres dispositifs comprenant une bobine de même géométrie, ou bien la constante C peut être déterminée de façon théorique selon la géométrie de la bobine.

Par contre, s'il se produit un court-circuit entre au moins deux spires de la bobine, la valeur du rapport R1/R2 entre les deux mesures de résistance R1 et R2 diffère notablement de ladite constante C. En effet, si un court-circuit se produit entre deux spires de la bobine 5, la partie de bobine comprenant ces deux spires court-circuitées a une résistance nettement inférieure à la résistance de la même partie de bobine ne comprenant aucune spire court-circuitée.

On peut ainsi détecter par une série de deux mesures sur une bobine d'une structure de circuit intégré adaptée, c'est-à-dire du type représentée en figure 2, si au moins deux spires sont court-circuitées dans ladite bobine.

Il va de soi pour l'homme de l'art que la description détaillée ci-dessus peut subir diverses modifications sans sortir du cadre de la présente invention.

## Revendications

1. Méthode de mesure sur une structure intégrée de puce (1) comprenant au moins une bobine (5) comprenant plusieurs spires (6), **caractérisée en ce qu'**elle comprend les étapes suivantes consistant à :
- mesurer les résistances aux bornes de première et seconde parties de la bobine (5), correspondant à deux nombres différents de spires de bobine;
- calculer le rapport entre les résistances mesurées aux bornes des première et seconde parties de la bobine (5);
- comparer ce rapport à une constante mesurée à partir d'un échantillon de mesures de résistance sur des bobines de même géométrie; et
- déterminer la présence ou l'absence d'un court-circuit entre au moins deux spires d'une des parties de la bobine (5), quand le rapport est différent ou égal à ladite constante, respectivement.

2. Structure de circuit intégré comprenant au moins une bobine (5) constituée d'une pluralité de spires (6), **caractérisée en ce que** la bobine (5) est pourvue en outre de plots de contact (10, 11, 12, 13, 12', 13') formés d'un seul bloc avec les spires et répartis sur les spires pour permettre la mesure de première et seconde résistances de première et seconde parties de bobine, qui correspondent à deux nombres différents de spires de bobine pour la mise en oeuvre de la méthode de mesure selon la revendication 1.

## Patentansprüche

1. Verfahren zum Messen auf einer integrierten Chipstruktur (1), die wenigstens eine Spule (5) mit mehreren Windungen (6) aufweist, **dadurch gekennzeichnet, dass** es die folgenden Schritte umfasst, die darin bestehen:
- die ohmschen Widerstände an den Anschlüssen des ersten und des zweiten Teils der Spule (5), die einer jeweils unterschiedlichen Anzahl von Spulenwindungen entsprechen, zu messen;
- das Verhältnis zwischen den ohmschen Widerständen, die an den Anschlüssen des ersten und des zweiten Teils der Spule (5) gemessen werden, zu berechnen;
dieses Verhältnis mit einer Konstante zu vergleichen, die anhand einer Probe für Messungen des ohmschen Widerstandes an Spulen, die dieselbe Geometrie aufweist, gemessen wird; und
- das Vorliegen oder Nichtvorliegen eines Kurzschlusses zwischen wenigstens zwei Windungen eines der Teile der Spule (5) zu bestimmen, wenn das Verhältnis verschieden von bzw. gleich der Konstante ist.

2. Integrierte Schaltungsstruktur, die wenigstens eine Spule (5) aufweist, die aus mehreren Windungen (6) gebildet ist, **dadurch gekennzeichnet, dass** die Spule (5) unter anderem mit Kontaktanschlussflächen (10, 11, 12, 13, 12', 13') versehen ist, die einteilig mit den Windungen ausgebildet und auf den Windungen verteilt sind, um die Messung eines ersten und eines zweiten ohmschen Widerstandes eines ersten bzw. zweiten Spulenteils, die einer jeweils unterschiedlichen Anzahl von Spulenwindungen entsprechen, ermöglichen, um das Messverfahren nach Anspruch 1 auszuführen.

## Claims

1. Method for measuring a chip integrated structure (1) including at least one coil (5) comprising a plurality of turns (6), **characterised in that** it comprises the following steps :
- measuring the resistances across the terminals of first and second portions of said coil (5), corresponding to two different numbers of turns of the coil;
- computing the ratio of the measured resistances across the terminals of first and second portions of said coil (5);
- comparing said ratio to a constant measured from a sample of resistance measurements made on coils of identical geometry; and
- determining the presence or the absence of a short circuit between at least two turns of one of said portions of said coil (5), when the ratio is different from or equal to said constant respectively.

2. Integrated circuit structure including at least one coil (5) comprising a plurality of turns (6), **characterised in that** coil (5) further includes contact pads (10,11,12,13,12',13') integral with said turns and placed on turns in order to allow the measurement of first and second resistances of first and second coil portions, which correspond to two different numbers of turns of the coil for implementing the measuring method according to claim 1.
